# EUROPÄISCHE PATENTANMELDUNG

(11) **EP 1 493 557 A1**
(43) Veröffentlichungstag der Anmeldung: **05.01.2005**
(21) Anmeldenummer: 04015318.1
(22) Anmeldetag: 30.06.2004
(51) Int. Cl.: B32B 17/10, B32B 27/36, G02F 1/15, B60J 7/00, H01L 31/048

(54) **Verfahren zur Herstellung eines Deckels mit einer Glasscheibe und elektrischen Funktionselementen**

(30) Priorität: 01.07.2003 DE 10329643
(71) Anmelder: Webasto AG, 82131 Stockdorf (DE)
(72) Erfinder: Erbeck, Gerit, 85467 Niederneuching (DE); Böhm, Hubert, 86926 Greifenberg (DE)
(74) Vertreter: Bedenbecker, Markus

(57) **Zusammenfassung**

Die Erfindung betrifft ein Verfahren zur Herstellung eines Deckels (11) mit einer Glasscheibe (14) für ein Fahrzeugdach, wobei zuerst eine Kombinationsfolie (10) mit einer Splitterschutzfolie und in die Kombinationsfolie integrierten elektrischen Funktionselementen (22, 24, 26, 28, 30) hergestellt wird und anschließend die Kombinationsfolie auf die dem Fahrzeuginnenraum zugewandte Seite der Scheibe fest angebracht wird. Ferner betrifft die Erfindung einen Deckel für ein Fahrzeugdach.

## Beschreibung

Die vorliegende Erfindung betrifft ein Verfahren zur Herstellung eines Deckels mit einer Glasscheibe und elektrischen Funktionselementen.

Mit elektrischen Funktionselementen versehene Deckel für eine Öffnung in einem Fahrzeugdach bzw. Vollglasdächer sind in verschiedenen Ausführungsformen bekannt. So offenbart beispielsweise die EP 1 234 721 A2 einen verstellbaren Deckel, welcher mit einem flächigen Beleuchtungselement versehen ist. Als Beleuchtungselemente kommen dabei z.B. Elektrolumineszenz- (EL) Folien zum Einsatz. Die benötigten Schichten (Elektroden, EL Schicht, Schutzfolien, usw.) werden sukzessive aufgebracht. Will man in einem transparenten Bereich eines Fahrzeugdachs dessen Lichtdurchlässigkeit durch Anlegen einer Spannung steuern, so werden elektrochrome (EC) Elemente verwendet. Beispiele für solche elektrochromen Beschichtungen zeigen die DE 197 23 596 C1 und die DE 196 30 812 A1. Alternative Elemente zur Steuerung der Lichtdurchlässigkeit von transparenten Fahrzeugflächen sind Flüssigkristallelemente (LCD) und SPD-Schichten (Suspended Particle Device). Ein Beispiel für ein solches Fahrzeugscheibensystem findet sich in der DE 100 43 141 A1. Will man z.B. den Deckel eines Schiebedachs als Spannungsquelle nutzen, so kommen Solarelemente aus Halbleiterwerkstoffen zum Einsatz. Beispiele hierfür sind in der DE 43 23 140 A1 und der FR 2 673 768 A1 gezeigt. Will man verhindern, dass bei einem Unfall ein Glasdeckel zum Verschließen einer Öffnung in einem Fahrzeugdach versplittert und die Öffnung freigibt, so können reiß- und kratzfeste Splitterschutzfolien an der Scheibenunterseite des Glasdeckels angeklebt werden. Ein Beispiel hierzu findet sich in der DE 101 51 156 A1.

Nachteilig bei diesen bekannten Möglichkeiten zur Integration elektrischer Funktionselemente in Deckel für Fahrzeugdächer ist der sukzessive Aufbau des Schichtverbundes während der Fertigung des Deckels. Da der Schichtverbund z.B. bei einem Glasdeckel im einfachsten Fall aus Glas / Klebeschicht / Funktionselement / Klebeschicht / Schutzfolie besteht, ist der Aufbau aufwändig und birgt außerdem das Risiko von Staubeinschlüssen oder Laminationsfehlern. Dadurch entstehen höhere Herstellkosten. Darüber hinaus lassen sich auf diese Weise Kombinationen von unterschiedlichen Funktionselementen nur schwer herstellen. In manchen Fällen, z.B. bei den EC-Beschichtungen, muss eine sphärisch gewölbte Scheibe mit einem Vakuumverfahren beschichtet werden, was bei den kleinen Stückzahlen hohe Kosten bedeutet. Bekannte EL-Folien können wegen der Sprödigkeit der für die Elektroden verwendeten ITO-Schichten nur in großen Radien verarbeitet werden.

Es ist Aufgabe der vorliegenden Erfindung, ein Herstellungsverfahren für einen Fahrzeugdach-Deckel mit einer Glasscheibe zu schaffen, bei dem der Deckel auf möglichst einfache Weise und zuverlässige Weise mit elektrischen Funktionselemente versehen werden kann. Ferner soll mittels der Erfindung ein solcher Deckel geschaffen werden.

Diese Aufgabe wird erfindungsgemäß gelöst durch ein Verfahren gemäß Anspruch 1 bzw. durch einen Deckel gemäß Anspruch 22. Bei der erfindungsgemäßen Lösung ist vorteilhaft, dass dadurch, dass die elektrischen Funktionselemente bereits vor dem Aufbringen auf die Deckelscheibe in einer Kombinationsfolie integriert werden, sich die eigentliche Herstellung des Deckels wesentlich vereinfacht, da nur noch eine Folie aufgebracht werden muss anstatt mehrere separate Lagen, und das Risiko von Staubeinschlüssen und/oder Laminationsfehlern bei der Anbringung der elektrischen Funktionselemente an der Scheibe deutlich reduziert werden kann. Dies reduziert die Herstellkosten wesentlich. Ferner können auch Kombinationen von unterschiedlichen Funktionselementen auf dem Deckel einfacher realisiert werden. Durch die Integration der elektrischen Funktionselemente in der Kombinationsfolie entfällt weiterhin die Schwierigkeit der genauen Positionierung von ansonsten separaten Folien bei der Aufbringung auf der Deckelscheibe. Außerdem kann ein Aufschwimmen im Foliensandwich während des Laminationsvorgangs verhindert werden. Damit sind insgesamt wesentlich aufwändigere Designvarianten realisierbar.

Bei der Lösung gemäß Anspruch 22 ist ferner vorteilhaft, dass dadurch, dass die Splitterschutzfolie selbst bereits einen Teil der Funktionselemente bildet oder als Träger derselben wirkt, zusätzliche Folien eingespart werden können, wodurch ein Deckel mit reduzierter Dicke - und damit reduziertem Bauraumbedarf- geschaffen werden kann.

Der Begriff "elektrische Funktionselemente" soll hier alle elektrischen Komponenten einschließlich elektrisch wirksamer Beschichtungen und Schichten erfassen.

Bevorzugte Ausgestaltungen der Erfindung ergeben sich aus den Unteransprüchen.

Im folgenden wird die Erfindung anhand der beigefügten Figuren beispielhaft näher erläutert.

Es zeigt:
- Fig. 1: einen Schnitt durch einen Fahrzeugdach-Deckel mit elektrischen Funktionselementen entsprechend dem Stand der Technik;
- Fig. 2: einen Schnitt durch einen erfindungsgemäßen Fahrzeugdach-Deckel, bei dem die elektrische Funktionselemente in einer Kombinationsfolie enthalten sind;
- Fig. 3: eine' Ansicht von oben auf einen erfindungsgemäßen Glasdeckel zum Verschließen einer Öffnung in einem Fahrzeugdach mit integrierten elektrischen Funktionselementen; und
- Fig. 4: eine Ansicht wie Fig. 3, wobei eine abgewandelte Ausführungsform gezeigt ist.

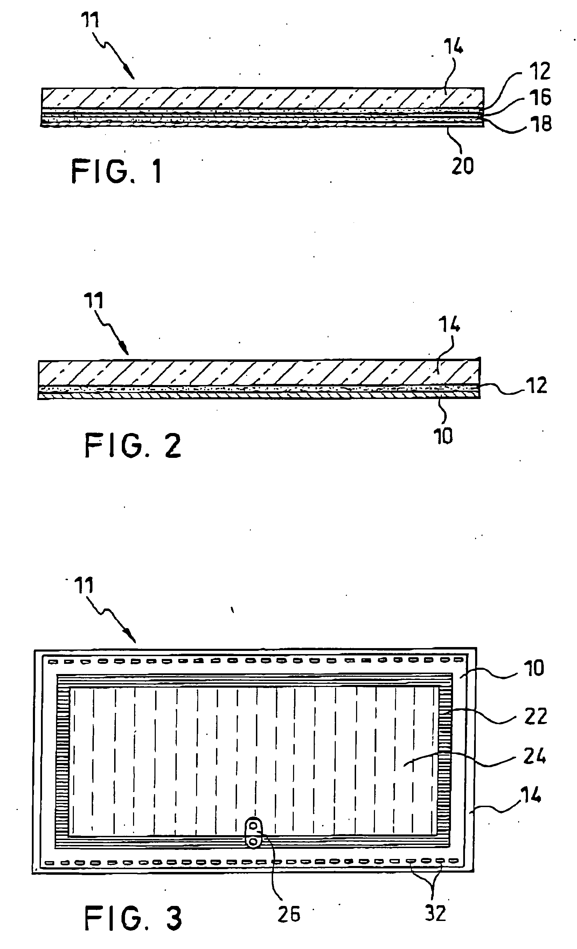

Fig. 1 zeigt eine Schnittansicht durch einen Glasdeckel 11 eines Fahrzeugdachs, in den auf herkömmliche Weise elektrische Funktionselemente integriert sind. Hierzu ist eine mit elektrischen Funktionselementen versehene Folie 16 mittels einer Schmelzklebefolie 12 auf die Unterseite einer Glasscheibe 14 auflaminiert. Auf die Folie 16 mit den Funktionselementen ist mittels einer weiteren Schmelzklebefolie 18 eine Splitterschutzfolie 20 auflaminiert, welche die Folie 16 mit den Funktionselementen und die Scheibe 14 vor Umwelteinflüssen und Zerkratzen schützen soll und bei Bruch der Scheibe 14 verhindern soll, dass Splitter in den Fahrzeuginnenraum fallen. Dieser Aufbau ist -obwohl er nur wenige Schichten enthält- bereits relativ aufwändig zu verarbeiten und bringt außerdem das Risiko von Staub- und Lufteinschlüssen beim sukzessiven Aufbringen der verschiedenen Schichten. Beim Laminieren der unterschiedlichen Schichten sollte insbesondere gewährleistet sein, dass eine optisch einwandfreie Durchsicht durch den Glasdeckel 14 erhalten bleibt.

Demgegenüber zeigt Fig. 2 einen Schnitt durch eine erfindungsgemäßen Glasdeckel 11. In diesem Fall integriert der Kunststofffolienhersteller die elektrischen Funktionselemente bereits bei der Herstellung der Folie zu einer Kombinationsfolie 10, welche mittels einer Schmelzklebefolie 12 auf die Unterseite der Glasscheibe 14 laminiert wird. Für die thermische Lamination wird kann ein Laminator oder ein Autoklav verwendet werden.

Alternativ kann die Kombinationsfolie 10 auch mit einem Kleber, z.B. einem PU- oder Acrylharzkleber, auf die Unterseite der Glasscheibe 14 aufgeklebt werden.

Zur Herstellung der Kombinationsfolie 10 können die elektrischen Funktionselemente z.B. mit einem Beschichtungsverfahren wie Vakuumbeschichtung oder vorzugsweise Siebdruck oder durch Aufkleben auf eine erste Folie aufgebracht werden. Als elektrische Funktionselemente können z.B. Elektrolumineszenzelemente, elektrochrome Elemente, SPD (Suspended Particle Device)-Elemente, Flüssigkristallelemente, Touch Pads, Lichtstreuelemente, Dünnschichtsolarzellen, transparente Solarzellen oder organische Leuchtdioden (Organic Light-emitting Diodes, OLED) zum Einsatz kommen.

Zum Einschluß der Funktionselemente kann eine zweite Folie auf die erste aufkaschiert werden, um die Kombinationsfolie 10 zu erhalten, oder die erste Folie fungiert selbst als Teil bzw. Träger der zu realisierenden Funktionselemente. Um einen Splitterschutz erreichen, ist eine der Folien, vorzugsweise die dem Fahrzeuginnenraum am nächsten zugewandte Folie, eine Splitterschutzfolie aus z.B. Polycarbonat oder Polyethylenterephtalat. Als Schmelzklebefolien können entsprechend des Materials der Splitterschutzfolie z.B. Schmelzklebefolien aus PVB oder TPU verwendet werden.

Zur Fixierung der Splitterschutzfolie am Deckelrand ist diese mit einer Perforation 32 versehen, die in eine Randumschäumung des Deckels eingeschäumt ist und in welche diese eingreifen kann.

Falls es sich bei den Funktionselementen um LCD-Schichten handelt, kann eine IRreflektierende Beschichtung zur Verlängerung der Lebensdauer vorgesehen sein. Für SPD-Elemente kann aus dem selben Grund eine UV-reflektierende Beschichtung vorgesehen sein.

Als Elektrodenmaterial zur Kontaktierung der elektrischen Funktionselemente kommen vorzugsweise leitfähige Polymere, ähnlich wie sie in der DE 198 41 803 A1 oder der DE 195 07 413 A1 beschrieben werden, zum Einsatz. Dadurch können auch kleine Biegeradien realisiert werden.

Die elektrische Isolation der Kontaktierung gegenüber der Schmelzklebefolie 12 kann durch eine geeignet isolierende Beschichtung in der Kombinationsfolie 10 erreicht werden.

Ein Beispiel für die Integration verschiedener elektrischer Funktionselemente in eine Kombinationsfolie 10 zur Herstellung eines Glasdeckels 11 für eine Öffnung in einem Fahrzeugdach, ist in Fig. 3 gezeigt. Hier ist eine Glasscheibe 14 mit einer Kombinationsfolie 10 beschichtet, in deren Mitte sich ein LCD-, SPD- oder EC-Bereich 24 befindet, der von einem streifenförmigen Elektrolumineszenzelement 22 umgeben ist. Die einzelnen Funktionselemente werden über integrierte Touch Pads 26 geschaltet.

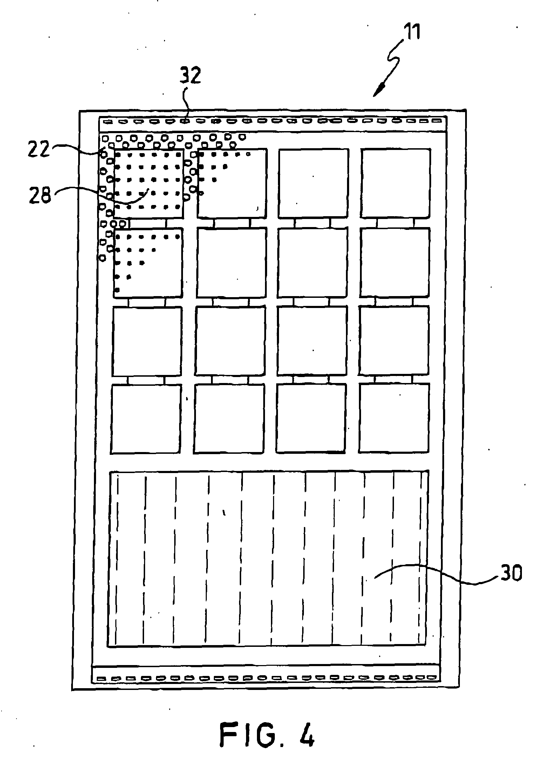

Fig. 4 zeigt ein weiteres erfindungsgemäßes Fahrzeugflächenteil, bei dem Elektrolumineszenzelemente 22 zusammen mit transparenten Solarzellen 28 und einem EC - Bereich 30 integriert sind. Die EL-Bereiche können dabei als Lochraster mit transparenten Löchern ausgebildet sein, um ein den transparenten Solarzellen 28 ähnliches Aussehen zu erzielen. Durch den EC-Bereich 30 ist zusätzlich noch ein abdunkelbarer Durchsichtbereich ini derartig gestalteten Glasdeckel integriert.

Im Falle der transparenten Solarzellen kann zur Vereinfachung der Fertigung ein reines Kunststofffolienmodul durch Verwendung eines Walzenlaminators hergestellt werden, welches dann auf den Glasdeckel laminiert wird. Diese Anwendung ist aber nicht nur auf ganz oder teilweise transparente/transluzente Glasdeckel beschränkt, sondern kann auch bei einem nicht transparenten Deckel mit herkömmlichen, kristallinen oder polykristallinen Solarzellen realisiert werden.

### Bezugszeichenliste

- 10: Kombinationsfolie
- 11: Glasdeckel
- 12: Schmelzklebefolie
- 14: Glasscheibe
- 16: Folie mit Funktionselement
- 18: Schmelzklebefolie
- 20: Schutzfolie
- 22: Elektrolumineszenzelement
- 24: LCD-, SPD-, EC-Bereich
- 26: Touch Pad
- 28: Transparente Solarzelle
- 30: EC-Bereich
- 32: Perforation

## Patentansprüche

1. Verfahren zur Herstellung eines Deckels (11) mit einer Glasscheibe (14) für ein Fahrzeugdach, wobei zuerst eine Kombinationsfolie (10) mit einer Splitterschutzfolie und in die Kombinationsfolie integrierten elektrischen Funktionselementen (22, 24, 26, 28, 30) hergestellt wird und anschließend die Kombinationsfolie auf der dem Fahrzeuginnenraum zugewandten Seite der Scheibe fest angebracht wird.

2. Verfahren gemäß Anspruch 1, **dadurch gekennzeichnet, dass** zur Herstellung der Kombinationsfolie (10) die Funktionselemente (22, 24, 26, 28, 30) auf eine erste Folie durch Beschichtung aufgebracht werden.

3. Verfahren gemäß Anspruch 2, **dadurch gekennzeichnet, dass** als Beschichtungsverfahren Vakuumbeschichtung oder Siebdrucken verwendet wird.

4. Verfahren gemäß Anspruch 1, **dadurch gekennzeichnet**, dass' zur Herstellung der Kombinationsfolie (10) die Funktionselemente (22, 24, 26, 28, 30) auf eine erste Folie aufgeklebt werden.

5. Verfahren gemäß einem der vorhergehenden Ansprüche, **dadurch gekennzeichnet, dass** die Funktionselemente (22, 24, 26, 28, 30) mit Kontaktelektroden aus leitfähigem Polymermaterial versehen werden.

6. Verfahren gemäß einem der vorhergehenden Ansprüche, **dadurch gekennzeichnet, dass** auf die Funktionselemente (22, 24, 26, 28, 30) nach dem Kontaktieren eine Isolationsbeschichtung aufgebracht wird.

7. Verfahren gemäß einem der vorhergehenden Ansprüche, sofern auf Anspruch 2 oder 4 rückbezogen, **dadurch gekennzeichnet, dass** nach dem Aufbringen der Funktionselemente (22, 24, 26, 28, 30) auf die erste Folie und nach dem elektrischen Kontaktieren eine zweite Folie auf die Funktionselemente aufgebracht wird.

8. Verfahren gemäß Anspruch 2, 3 oder 4, **dadurch gekennzeichnet, dass** es sich bei der ersten Folie um die Splitterschutzfolie handelt.

9. Verfahren gemäß einem der vorhergehenden Ansprüche, **dadurch gekennzeichnet, dass** die Kombinationsfolie (10) mit den Funktionselementen (22, 24, 26, 28, 30) auf die Scheibenunterseite mittels einer Schmelzklebefolie (12) auflaminiert oder mittels eines Klebers aufgeklebt wird.

10. Verfahren gemäß Anspruch 9, **dadurch gekennzeichnet, dass** für die Lamination ein Laminator oder ein Autoklav verwendet wird.

11. Verfahren gemäß einem der vorhergehenden Ansprüche, **dadurch gekennzeichnet, dass** die elektrischen Funktionselemente Elektrolumineszenzelemente (22), elektrochrome Elemente (24, 30), SPD (Suspended Particle Device)-Elemente (24), Flüssigkristallelemente (24), Touch Pads (26), Lichtstreuelemente, Dünnschichtsolarzellen, transparente Solarzellen (28) oder organische Leuchtdioden (OLED) sind.

12. Verfahren gemäß einem der vorhergehenden Ansprüche, **dadurch gekennzeichnet**, der Deckel (11) transparent ist.

13. Verfahren gemäß Anspruch 4, **dadurch gekennzeichnet, dass** die Kombinationsfolie (10) zumindest in Teilbereichen transparent ist.

14. Verfahren gemäß einem der vorhergehenden Ansprüche, **dadurch gekennzeichnet, dass** der Deckel (11) fest in einer Dachöffnung montiert ist oder verstellbar ist, um eine Dachöffnung wahlweise zu verschließen bzw. mindestens teilweise freizugeben.

15. Verfahren gemäß Anspruch 8, **dadurch gekennzeichnet, dass** die Splitterschutzfolie eine Polycarbonat- oder Polyethylenterephthalatfolie ist.

16. Verfahren gemäß Anspruch 8 oder 15, **dadurch gekennzeichnet, dass** die Splitterschutzfolie mit einer Perforation (32) versehen wird, die in eine Randumschäumung des Deckels (11) eingeschäumt wird.

17. Verfahren gemäß Anspruch 9, **dadurch gekennzeichnet, dass** als Kleber ein PU (Polyurethan) - oder Akrylharzkleber verwendet wird.

18. Verfahren gemäß Anspruch 9, **dadurch gekennzeichnet, dass** als Schmelzklebefolie (12) eine PVB (Polyvinylbutyral)- oder eine TPU (thermoplastisches Polyurethan)- Folie verwendet wird.

19. Verfahren gemäß einem der vorhergehenden Ansprüche, **dadurch gekennzeichnet, dass** in die Kombinationsfolie (10) eine IR- und / oder eine UV-reflektierende Schicht eingebracht wird.

20. Verfahren gemäß einem der vorhergehenden Ansprüche, **dadurch gekennzeichnet, dass** die Kombinationsfolie (10) an verschiedenen Stellen mit unterschiedlichen Funktionselementen (22, 24, 26, 28, 30) versehen wird.

21. Verfahren gemäß einem der vorhergehenden Ansprüche, **dadurch gekennzeichnet, dass** in die Kombinationsfolie (10) Berührungsschalter (26) integriert werden, um die einzelnen Funktionselemente (22, 24, 28, 30) zu schalten.

22. Deckel für ein Fahrzeugdach, mit einer Glasscheibe (14) und einer Kombinationsfolie (10), die von einer Splitterschutzfolie gebildet wird, welche an ihrer der Glasscheibe zugewandten Seite als Träger für elektrische Funktionselemente (22, 24, 26, 28, 30) oder als Teil derselben dient und auf der dem Fahrzeuginnenraum zugewandten Seite der Scheibe mittels einer Schmelzklebefolie (12) auflaminiert oder mittels eines Klebers aufgeklebt ist.
